Europäisches Patentamt

**European Patent Office**

Office européen des brevets

(19)

(11) Publication number: **0 225 748**
A2

(12)

# EUROPEAN PATENT APPLICATION

(21) Application number: **86308970.2**

(22) Date of filing: **18.11.86**

(51) Int. Cl.⁴: **H 01 H 13/70, H 03 K 17/98**

(30) Priority: **27.11.85 IT 6799485**

(43) Date of publication of application: **16.06.87**
Bulletin 87/25

(84) Designated Contracting States: **CH DE ES FR GB LI NL SE**

(71) Applicant: **Ing. C. Olivetti & C., S.p.A., Via G. Jervis 77, I-10015 Ivrea (Turin) (IT)**

(72) Inventor: **Sella, Lino, Via Castellamonte, 33B, I-10010 Banchette d'Ivrea (TO) (IT)**
Inventor: **Franchino, Giovanni, Via M. d'Azeglio, 9, I-10010 Tavagnasco Torino (IT)**
Inventor: **Matarazzo, Alessandro, Via Stelvio, 70, I-10100 Torino (IT)**
Inventor: **Ronco, Angelo, Via Sondrio, 3, I-10036 Settimo Torinese Torino (IT)**

(74) Representative: **Pears, David Ashley et al, REDDIE & GROSE 16 Theobalds Road, London WC1X 8PL (GB)**

(54) **Multilayer capacitive keyboard membrane.**

(57) The membrane is a sandwich of three dielectric layers 3, 5, 4 bonded together by adhesive films 21 with openings 22 in the intermediate layer 5 at each key position. Conductive pads 8, 18 on the inner surface of the outer layers 3, 4 face each other across the opening 22 and register with a conductive pad 20 on the outer surface of the layer 4. The pads 8 are connected in columns by conductive tracks 24 to a pulse generator 38 which pulses the columns sequentially. The pads 20 are connected in rows by conductive tracks 28 to a multipled analog to digital converter 42. The capacitance at a key position is made up of the fixed capacitance between the pads 18, 20 on the layer 4 and the capacitance between the opposed pads 8, 18, which is increased by local pressure on the layer 3.

0225748

6B28320

## MULTILAYER CAPACITIVE KEYBOARD MEMBRANE

The present invention relates to a multi-layer capacitive membrane for keyboards of office machines and data processing apparatuses, comprising a plurality of flexible layers of dielectric material, on which, in association with each key, is disposed a group of conducting areas capable of defining a predetermined capacitance, the value of which is varied by actuation of the key.

Modern office and data processing machines increasingly use simple electronic keyboards of limited thickness.

A capacitive keyboard is known, which comprises a multi-layer membrane made up from four layers or sheets of insulating material which are arranged in superposed relationship. The first two layers which are separated by a third spacer layer carry at corresponding positions conducting pads or areas which are disposed in mutually facing relationship through openings in the spacer layer. The fourth layer carries conducting pads which are disposed on the surface in contact with the second layer. The multi-layer membrane is therefore relatively complicated and expensive to manufacture.

In addition, since each trio of mutually aligned pads or areas forms a capacitor formed by pairs of facing pads on two different layers, that membrane suffers from the disadvantage that bubbles of air or traces of glue may remain trapped during the assembly phase between the pads of the fourth layer and the surface of the second layer, causing an unacceptable variation in the capacitance values of the capacitor, in spite of the fact that the thickness of the second layer is constant.

The object of the present invention is to provide a capacitance membrane of the above-indicated type which is simple and economical to manufacture and in which the capacitance of the capacitor remains rigorously constant.

The invention thus provides a capacitance keyboard characterised in the manner set forth in claim 1.

The invention will now be further described, by way of example, with reference to the accompanying drawings, in which:

Figure 1 is a diagrammatic view in partial section of a portion of the capacitance membrane in accordance with a preferred embodiment of the invention;

Figure 2 shows a portion of Figure 1 in the operating position;

Figure 3 is a sectional view of a key associated with the membrane of Figure 1;

Figure 4 is a view in section taken along line IV-IV in Figure 1;

Figure 5 is a view taken along line V-V in Figure 1; and

Figure 6 shows diagrams illustrating the electrical control signals of the keyboard.

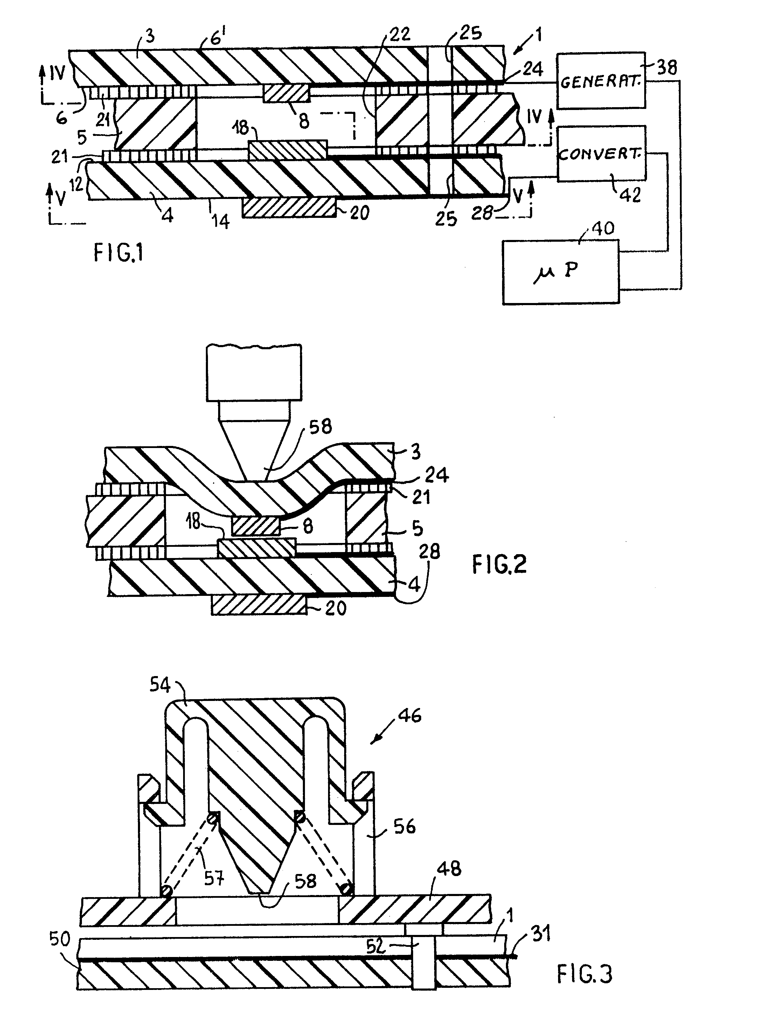

Referring to Figure 1, shown therein in section is a limited part of a keyboard membrane comprising a multi-layer membrane 1 having three layers 3, 4 and 5. In Figure 1, the thickness of the layers is shown enlarged for the sake of clarity.

The first external layer 3 is a thin flexible layer or sheet of electrically insulating material. Conducting areas or pads 8 are provided on the inside surface 6 of the first layer 3.

A second external layer 4 of electrically insulating material has pads 18 on its inside surface 12, registering with the pads 8, and registering pads 20 on its outer surface 14. The two layers 3 and 4 and an inner layer 5 which is also of insulating material are bonded together in a sandwich structure, by adhesive films 21. The layer 5 acts as a spacer maintaining the inner surfaces 6 and 12 of the layers 3 and 4 at a constant and properly defined spacing.

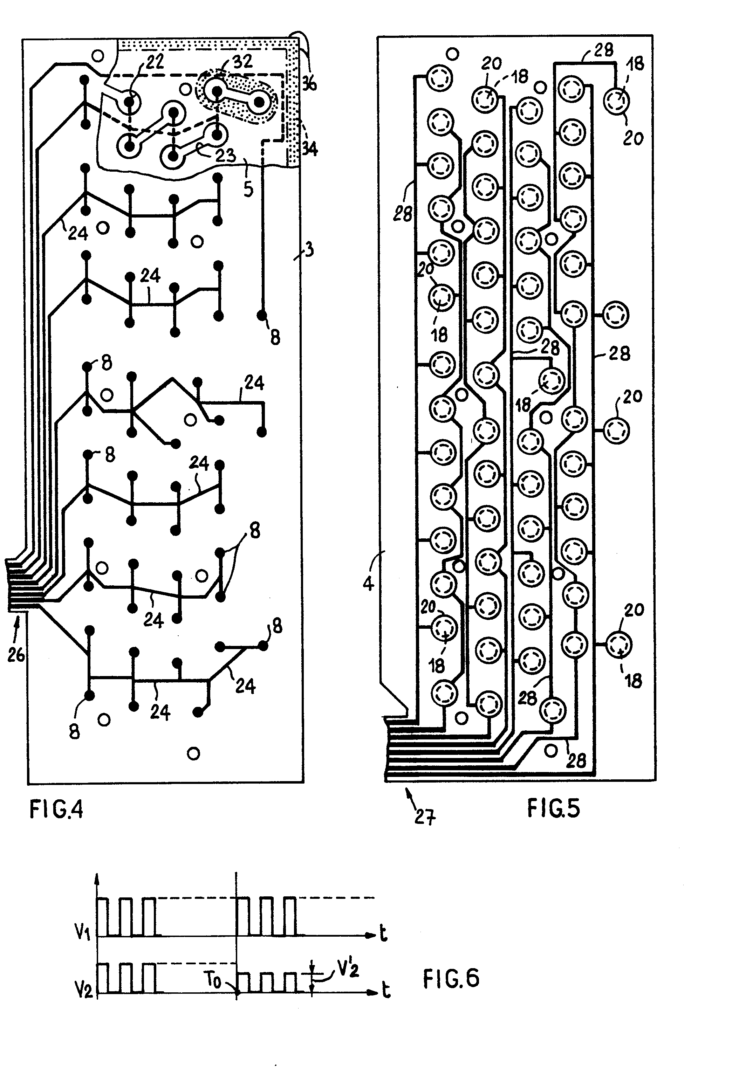

The spacer layer 5 has through openings 22 registering with the pads 8 and 18. Pairs of openings 22 are connected together by channels 23 (see Figure 4) to provide a vent for the air enclosed in the cavities of the openings 22.

The pads 8, 18, 20 and the openings 22 are disposed on the respective layers 3, 4 and 5 to form a matrix of rows and columns of conducting areas, as can be clearly seen from Figures 4 and 5. In order to ensure that the pads 8, 18, 20 and openings 22 all register, the layers 3, 4, 5 are all provided with reference holes 25 for ensuring correct relative positioning during assembly.

The conducting areas 8 are connected together in groups by conducting tracks 24 on the surface 6 of the first layer 3. The areas 18 which are disposed on the surface 12 of the second layer 4 are insulated from each other while the corresponding areas 20 are connected to each other in groups by conducting tracks 28.

The tracks 24 and 28 are extended from the layers 3 and 4 by ribbon cables 26 and 27, connected to a logic circuit which will be described below.

Construction of the multi-layer membrane 1 is as follows. The two opposite faces of the spacer layer 5 are covered by films 21 of a thickness of between 5 and 15 μm of adhesive, for example a glue containing acrylic resin. The layers 3 and 4 are then pressed from opposite sides against the intermediate layer 5, thus producing the multi-layer membrane 1. A protective layer 31 (see Figure 3) is applied to the outside face 14 of the layer 4; the protective layer 31 can be a sheet of dielectric paper or equivalent material.

In order to use a consistent small amount of expensive glue, the glue is applied only in limited zones 32 enclosing at least two openings 22, as shown in Figure 4. A strip 34 of glue is also applied along the edges 36 of the intermediate layer 5 to ensure a sealing closure between the layers 3 and 4 and the intermediate layer 5. The layer 3 is to be sufficiently thin to be able to be deformed within the opening 22 under the effect of an external pressure, as indicated in Figure 2.

The layers 3 and 4 and the spacer layer 5 may be of Mylar (Trade Mark) or other known dielectric material.

The layers 3 and 4 are of a thickness of from 10 to 100 μm, preferably 75 μm; the thickness of the spacer layer 5 is between 100 and 200 μm and preferably 150 μm.

Alternatively, the spacer layer 5 may be produced by means of a single layer of constant thickness of between 30 and 50 μm of a pressure-sensitive glue, for example "Pressure Adhesive 467" (Trade Mark)from 3M, which is spread over the surface 12 of the support 4 in the regions which are free from the conducting areas 18.

In this case also, as indicated hereinbefore, the glue may be applied only in limited regions around the areas 18 on the surface 12 of the support 4, care being taken to leave free from glue a circular ring around those areas. That may be effected for example by using masks positioned over the areas 18. The areas 8, 18, 20 and the paths 24 and 28 are produced by means of the known screen printing process, by depositing a silver-base compound on the dielectric supports.

Alternatively, they may be produced using other known procedures such as for example photodeposition, metal plating and so on. The thickness of the conducting pads 8, 18 and 20 is around 15 $\mu$m and they have a circular contour of diameters of 4 mm, 10 mm and 11 mm respectively.

When the assembly has been formed, each trio of areas 8, 18 and 20 which are aligned with each other form two capacitors which are electrically in series with each other. The areas 8 and 18 which face each other through the openings 22 form a first plurality of capacitors of a predetermined capacitance $C_1$, for example between 1.5 and 3 pF. The pairs of areas 18 and 20 which are separated by the constant thickness of the support 4 form a second plurality of capacitors of a constant capacitance $C_2$ of around 30 pF. The areas 20 have a surface which is slightly larger than the areas 18 in order to minimise the influence of possible mis-alignment between the two areas on the value of the capacitance $C_2$ of the capacitors formed by various pairs of areas 18 and 20. The areas 8 have a surface area which is markedly less than that of the areas 18 and 20 in order to limit to the maximum degree the risk of damage because of flexing when the portion of support 3 on which the areas 8 are disposed is deformed during actuation of the membrane 1, as described hereinafter.

Actuation of the membrane 1 is effected by means of keys, one of which is diagrammatically indicated at 46 in Figure 3. The key 46 is mounted on a structure 48 which is disposed above the membrane 1 in such a way that the key 46 is aligned with the trio of areas 8, 18 and 20. The structure 48 is fixed on a support plate 50 on which the membrane 1 is also fixed by means of pegs 52 passing through the reference holes 25 in the membrane 1.

The key 46 comprises a body 54 which is slidable perpendicularly to the keyboard 1 along guides 56 and held in position in Figure 3 by a spring 57. When the body 5 is aligned, a

- 5 -

terminal portion 58 of the body 54 presses against the layer 3 at a
position corresponding to the area 8 in Figure 1 and deforms the
support into the opening 22 (see Figure 2). The areas 8 and 18 are
brought towards each other or at the limit situation brought into
contact with each other with a resulting variation in the
capacitance $C_1$.

The logic circuit comprises a circuit 38 (Figure 1) for
generating voltage pulses, which is controlled by a microprocessor
40 and connected to the areas 8 by way of the paths 24 for applying
the constant voltage pulses $V_1$ to the capacitors $C_1$ and $C_2$ (see
Figure 6).

The logic circuit further comprises an analog-digital
conversion circuit 42 (see Figure 1) of known type which is
connected by way of the paths 28 to the areas 20 and also connected
to the microprocessor 40 for detecting the variations in the voltage
$V_2$ which occur on the areas 20, caused by the variations in the
capacitance $C_1$, and to transmit them to the microprocessor 40.
When the key 46 is depressed (Figure 4), the end 58 thereof deforms
the layer 3, causing a variation in the capacitance $C_1$. The
voltage pulses $V_2$ have a first, high value. When the key is
released at time To, the pulses fall to a lower value $V'_2$. The
microprocessor 40 interprets the higher level $V_2$ as an actuation
signal of the key 46. The pulse generator 38 pulses the column
tracks 24 in cyclic sequence and the analog to digital converter 42
senses the row tracks 28 in cyclic sequence, in known manner.

In accordance with an alternative form of the present
invention, the membrane 1 may be actuated directly by a finger of
the operator.

In that case, to identify the regions to which pressure is to
be applied by means of a finger, the layer 3 carries on its upper
surface 6' (Figure 1), at positions corresponding to the areas 8, a
symbol which is distinctive of the area to be pressed, for example a
circle. By the pressure applied by a finger, the support 3 is
deformed into the opening 22 (see Figure 2) to cause the variation
in the capacitance $C_1$. In that alternative form the membrane may
be mounted in a limited space, for example on a control panel of an
electronic apparatus.

CLAIMS

1. A multi-layer capacitive keyboard membrane comprising a plurality of flexible layers (3,4,5) of dielectric material, on which is disposed a group of conducting areas (8,18) capable of defining a predetermined capacitance, the value of which is varied by local pressure on the membranes, characterised in that one of the layers (4) is provided on the two faces (12,14) thereof with a pair of registering conducting areas (18,20) for supplying a constant part ($C_2$) of the capacitance.

2. A membrane according to claim 1, characterised in that a second layer (3) carries a third conducting area (8) capable of forming with one of the conducting areas (18) of the said pair (18,20) another part ($C_1$) of the capacitance which can be varied by local pressure on the membrane, the first and second layers (4,3) being sandwiched together with an intermediate layer (5) having an opening (22) at each position corresponding to a group of conducting areas (8,18,20).

3. A membrane according to claim 2, characterised in that at least two of the openings (22) are connected together by a channel (23).

4. A membrane according to claim 2 or 3, characterised in that the conducting areas (20) on one face of the first layer (3) and those of the second layer (3) are connected to a logic circuit (38,42) by groups of parallel conductors (24,28).

5. A capacitive membrane according to claim 4, characterised in that the conducting areas (20) on the outer surface (14) of the first layer (4) and the conducting areas (8) on the second layer (3) are arranged in configurations of rows and columns in which the conducting areas belonging to each column or row are connected by a conducting track (24) to a source (38) of signals of the logic circuit and the conducting areas belonging to each row or column are connected by a conducting path (28) to an analog-digital converter circuit (42) of the logic circuit.

6.    A capacitive membrane according to claim 2, 3, 4 or 5, characterised in that the first and second layers (3,4) are bonded to opposite faces of the intermediate layer (5) by continuous films (21) of adhesive material.

7.    A capacitive membrane according to claims 2, 3, 4 or 5, characterised in that the first and second layers (3,4) are bonded to opposite forces of the intermediate layer (5) by localised films (32) of adhesive material around each of the conducting areas (8,18) on the inside faces of the first and second layers.

8.    A capacitive membrane according to any of claims 2 to 7, characterised in that the first and second layers (3,4) are of a thickness of between 10 and 100 μm and that the thickness of the intermediate layer (5) is between 100 and 200 μm.

9.    A capacitive membrane according to any of claims 2 to 8, characterised in that the conducting areas (18,20) on the first layer (4) are larger in diameter than the third area (8) to minimise variations in capacitance arising from possible mis-alignment as between the areas of the pair.

10.   A capacitive membrane according to any of the preceding claims, characterised in that the conducting areas (8,18,20) are of substantially circular shape and are about 15 μm in thickness.

FIG.1

FIG.2

FIG.3

0225748

FIG.4

FIG.5

FIG.6